**Europäisches Patentamt**

**European Patent Office**

**Office européen des brevets**

(19)

(11) Veröffentlichungsnummer: **0 143 176**
**B1**

(12) # EUROPÄISCHE PATENTSCHRIFT

(45) Veröffentlichungstag der Patentschrift:
**20.04.88**

(21) Anmeldenummer: **84109165.5**

(22) Anmeldetag: **02.08.84**

(51) Int. Cl.⁴: **B 60 H 1/00, H 01 C 1/084**

(54) **Kraftfahrzeug-Heizungs- und/oder Klimaanlage.**

(30) Priorität: **03.09.83 DE 3331890**

(43) Veröffentlichungstag der Anmeldung:
**05.06.85 Patentblatt 85/23**

(45) Bekanntmachung des Hinweises auf die Patenterteilung:
**20.04.88 Patentblatt 88/16**

(84) Benannte Vertragsstaaten:
**DE FR GB IT SE**

(56) Entgegenhaltungen:
**DE - A - 2 036 533**
**DE - A - 2 724 269**
**DE - B - 1 480 095**
**DE - B - 2 608 811**
**FR - A - 1 490 607**
**FR - A - 2 302 426**
**FR - A - 2 496 016**
**FR - A - 2 539 848**
**US - A - 3 028 800**

(73) Patentinhaber: **Süddeutsche Kühlerfabrik Julius Fr. Behr GmbH & Co. KG, Mauserstrasse 3, D-7000 Stuttgart 30 (DE)**

(72) Erfinder: **Dietzsch, Kurt, Dipl.-Ing., Göppinger Strasse 65, D-7250 Leonberg-Eltingen (DE)**
Erfinder: **Witzel, Karl-Heinz, Daimlerstrasse 38, D-7000 Stuttgart 50 (DE)**

ACTORUM AG

**Beschreibung**

Die Erfindung bezieht sich auf eine Kraftfahrzeug-Heizungs- und/oder Klimaanlage der im Oberbegriff des Patentanspruches 1 angegebenen Gattung.

Es sind bereits Heizungs- und Klimaanlagen für Kraftfahrzeuge bekannt, die über ein Gebläse, Wärmetauscher und Klappen zur Beeinflussung des Luftstromes verfügen. Es ist ferner aus der DE-A-2 724 269 bekannt, dass elektronische Bauteile, die mit erheblicher Wärmeentwicklung behaftet sind, in flächigem Kontakt mit geeigneten Kühlkörpern angeordnet werden sollen.

Die Anorndnung von Kühlflächen oder entsprechenden Kühlkörpern sollte möglichst so getroffen werden, dass eine ausreichende Wärmeabfuhr gesichert ist. So wurde beispielsweise in der US-A-2 786 173 bereits vorgeschlagen, einen Leistungswiderstand, an dem erhebliche Wärmeentwicklung auftrat, ausserhalb des Fahrgastraumes auf der Aussenseite der Spritzwand anzuordnen. Eine derartige Lösung ist jedoch insofern unpraktisch, da zusätzliche elektrische Leitungen und Anschlüsse erforderlich sind und die Anlage nicht komplett montierbar ist, sondern erst später im Fahrzeug zusammengefügt werden muss.

Es wurde bereits schon versucht, die mit erheblicher Wärmeentwicklung behafteten elektronischen Bauteile derart im Gebläsegehäuse anzuordnen, dass ein ständiger Luftstrom für eine gute Wärmeabfuhr von den Kühlelementen sorgt. Es hat sich dabei jedoch herausgestellt, dass eine erhebliche Beeinträchtigung der Luftströmung sowie eine erhebliche Geräuschentwicklung die Folgen einer derartigen Massnahme sind.

Aus der DE-B-2 608 811 ist eine Heizungs- und Lüftungs- oder Klimaanlage bekannt, die ein Gebläse, in dessen Luftansaugstutzen eine den Luftstrom sperrende, aus Metall bestehende Klappe angeordnet ist, umfasst. Zur Drehzahlregelung bzw. Abstufung des Gebläsemotors sind Vorschaltwiderstände vorgesehen, die in dem Ansaugkanal angeordnet sind und bei geöffneter Absperrklappe vom angesaugten Luftstrom gekühlt werden. Bei dieser bekannten Anordnung kann das Gebläse nur betrieben werden, wenn die Hauptluftklappe im Ansaugkanal geöffnet ist, da sonst eine ausreichende Wärmeableitung nicht gegeben ist. Die aus metallischem Werkstoff bestehende Klappe wirkt dabei als Hitzeschild für die aus Kunststoff bestehenden Wandteile des Gehäuses. Wegen der an die Klappenstellung gebundenen Funktionsbedingungen und der Thermoluftstromwirkung kann der Widerstand nur ausserhalb des Gehäuses der Heizungs- bzw. Klimaanlage angeordnet werden.

In der FR-A-1 490 607 ist eine Kraftfahrzeug-Heizungsanlage mit einem Gebläse und einer Absperrklappe beschrieben. Die Absperrklappe besteht aus einem metallischen Grundkörper mit einem rechtwinklig dazu angeordneten Seitenstück, auf dem unter Zwischenschaltung einer Epoxid-Harzschicht ein Rheostat angeordnet ist. Die Wärmeabfuhr ist dabei vom Öffnungsgrad der Klappe abhängig, das heisst bei fast oder vollständig geschlossener Klappe erfolgt überhaupt keine Wärmeabfuhr. Ausserdem ist der Wärmeübergang von dem Rheostaten auf das Seitenstück der Klappe unzureichend, da das Epoxid-Harz eine schlechte Wärmeleitfähigkeit besitzt.

In der FR-A-1 490 607 ist eine Kraftfahrzeug-Heizungsanlage mit einem Gebläse und einer Absperrklappe beschrieben. Die Absperrklappe besteht aus einem metallischen Grundkörper mit einem rechtwinklig dazu angeordneten Seitenstück, auf dem unter Zwischenschaltung einer Epoxid-Harzschicht ein Rheostat angeordnet ist. Die Wärmeabfuhr ist dabei vom Öffnungsgrad der Klappe abhängig, das heisst bei fast oder vollständig geschlossener Klappe erfolgt überhaupt keine Wärmeabfuhr. Ausserdem ist der Wärmeübergang von dem Rheostaten auf das Seitenstück der Klappe unzureichend, da das Epoxid-Harz eine schlechte Wärmeleitfähigkeit besitzt.

Es ist daher die Aufgabe der vorliegenden Erfindung, eine Kraftfahrzeug-Heizungs- und/oder Klimaanlage der gattungsgemässen Art (FR-A-1 490 607) zu schaffen, bei der ein mit erheblicher Wärmeentwicklung behaftetes elektronisches Bauteil unabhängig von der Luftstromführungsrichtung ausreichend und zuverlässig gekühlt wird und wobei die Luftströmung sowenig wie möglich beeinträchtigt wird.

Diese Aufgabe wird bei einer Kraftfahrzeug-Heizungs- und/oder Klimaanlage der bezeichneten Art erfindungsgemäss durch das kennzeichnende Merkmal des Anspruchs 1 gelöst.

Durch die erfindungsgemässe Anordnung wird nicht nur erreicht, dass eine gute Kühlung der elektronischen Bauteile gewährleistet ist, sondern darüber hinaus wird kein zusätzlicher Bauraum in der Anlage und keine geänderte Gehäusekonfiguration benötigt. Je nach Art und Ausführung der Anlage können die elektronischen Bauteile auf verschiedene Klappen, beispielsweise der Temperaturmischklappe oder einer Frischluft-/Umluft-Weiche, angeordnet sein. Aufgrund der Erfindung wird die ohnehin vorhandene Klappe dazu benutzt, die Funktion eines grossflächigen Kühlkörpers zu übernehmen. Da zumindest immer eine Seite der Klappe vom Luftstrom beaufschlagt ist, wird durch die relativ grosse wärmeleitende Fläche eine ausreichende Kühlung sichergestellt.

Zur Verbesserung der Wärmeverteilung in der Klappe wird vorgeschlagen, dass die Klappe im Bereich der elektronischen Bauteile Verdickungen aufweist. Derartige Verdickungen der Klappe lassen sich insbesondere dann auf einfache Weise anformen, wenn die Klappe als Fliesspressteil hergestellt wird.

Als elektronische Bauteile, die mit erheblicher Wärmeentwicklung behaftet sind, sind beispielsweise Leistungstransistoren oder Thermistoren zu nennen. Die auf der Klappe angeordneten elektronischen Bauelemente sind mittels eines Kabels an das Bordnetz des Fahrzeugs bzw. an eine Steuerungseinrichtung angeschlossen.

Die elektronischen Bauteile können je nach Art und Ausführung der Anlage auf einer dem Gehäuse nachgeschalteten Temperaturmischklappe oder auf einer der Saugseite des Gebläses angeordneten Frischluft-/Umluft-Weiche befestigt sein. Zur Optimierung der Luftströmung und/oder zur Vergrösserung der Wärme übertragungsfläche ist es zweckmässig, an der Klappe entsprechende Mittel vorzusehen. Derartige Mittel können durch entsprechend geformte Sicken im Material der Klappe, durch angeformte Rippen oder durch angeschweisste Blechstreifen gebildet sein.

Eine weitere Ausführungsform des Erfindungsgegenstandes besteht darin, dass auf der Rückseite der Klappe eine Leiterplatte befestigt ist, auf der die elektronische Steuerungseinrichtung angeordnet ist. Durch diese Massnahme wird eine weitere Integration erreicht, durch die die gesamte elektronische Einheit zur Gebläsesteuerung auf einer Leiterplatte möglich ist. Um für die Bauelemente der elektronischen Steuerungseinrichtung, die nicht in wärmeleitender Verbindung mit der Klappe stehen, den notwendigen Bauraum zu schaffen, wird vorgeschlagen, dass die Klappe eine zwischen den Leistungstransistoren befindliche Öffnung aufweist, die mit einer haubenförmigen Abdeckung versehen ist. Auf diese Weise können sich die Bauelemente der elektrischen Steuerungseinrichtung in die Öffnung der Klappe erstrecken, was dazu führt, dass zwischen der Leiterplatte und der Klappe lediglich ein geringer Abstand erforderlich ist. Anstelle der Öffnung in der Klappe und der haubenförmigen Abdeckung kann auch in der Klappe eine Wölbung vorgesehen sein, die den notwendigen Bauraum für die Bauelemente der elektronischen Steuerungseinrichtung schafft. Die Bauelemente der elektronischen Steuerungseinrichtung sind im Gegensatz zu den Leistungsbauteilen teilweise wärmeempfindlich. Es wird daher vorgeschlagen, die elektronische Steuerungseinrichtung in Kunstharz einzugiesen oder entsprechend abzudecken. Durch diese Massnahme werden ausserdem Luftverwirbelungen an den Bauelementen vermieden.

Wie bereits erwähnt, kann das mit Wärmeentwicklung behaftete elektronische Bauteil ein PTC-Widerstand sein. In diesem Fall ist es zweckmässig, dass der PTC-Widerstand einerseits an der Klappe grossflächig anliegt und mit seiner der Klappe abgewandten Seite an einer metallischen Platte liegt, wobei die Klappe sowie die Platte als elektrische Anschlüsse für den PTC-Widerstand dienen.

Um im Falle einer Reparatur das Auswechseln der elektronischen Bauteile zu erleichtern, ist es zweckmässig, dass die Klappe aus einem Rahmen und einer abnehmbaren Platte besteht und die elektronischen Bauteile auf der Platte befestigt sind. Dadurch braucht nicht die Klappe selbst aus der schwenkbaren Lagerung entfernt werden, sondern lediglich die Platte von dem Rahmen demontiert werden.

Es ist ausserdem von Vorteil, auf der Klappe einen Temperaturfühler anzuordnen, der im Falle einer zu grossen Wärmeentwicklung der elektronischen Bauteile die Steuerungseinrichtung für das Gebläse abschaltet und somit einen Schaden durch Überhitzung der elektronischen Bauteile vermeidet.

In der Zeichnung zeige:

Fig. 1 eine schematische Darstellung einer Kraftfahrzeug-Heizungsanlage mit auf der Temperaturmischklappe angeordneten elektrischen Bauteilen,

Fig. 2 einen Ausschnitt aus einer Kraftfahrzeug-Klimaanlage,

Fig. 3a die Draufsicht auf eine Absperrklappe mit darauf montierten Leistungstransistoren,

Fig. 3b einen Schnitt nach der Linie III-III in Fig. 3a,

Fig. 3c einen Schnitt nach der Linie II-II in Fig. 3a,

Fig. 4a eine Ausführungsvariante zu Fig. 3a,

Fig. 4b einen Schnitt nach der Linie IV-IV in Fig. 4a,

Fig. 4c eine Ausführungsvariante zu Fig. 4b,

Fig. 5 einen Schnitt durch eine Absperrklappe mit daran montiertem Thermistor,

Fig. 6 einen Schnitt durch eine Klappe mit Verdickungen und Rippen.

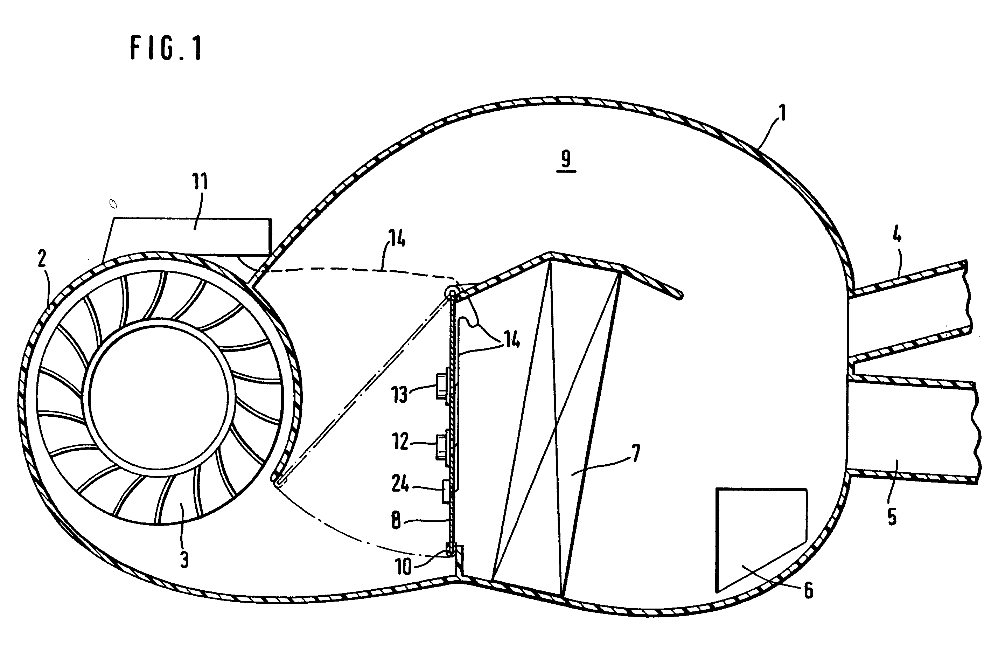

In Fig. 1 ist schematisch ein Gehäuse 1 einer Kraftfahrzeug-Heizungsanlage dargestellt, welches einerseits ein Spiralgehäuse 2 eines Radialgebläses 3 und andererseits mehrere Luftaustrittsstutzen 4, 5 und 6 aufweist. Zwischen dem Radialgebläse 3 und den Austrittsstutzen 4, 5 und 6 befindet sich ein Heizkörper 7 sowie ein den Heizkörper umgehender Bypass 9. Durch eine auf der Lufteintrittsseite des Heizkörpers 7 angeordnete und schwenkbar gelagerte Temperaturmischklappe 8 ist der Anteil von durch den Heizkörper 7 bzw. durch den Bypass 9 strömender Luft beeinflussbar. Die Temperaturmischklappe besteht aus einem Material mit guter Wärmeleitfähigkeit und ist an ihrem Umfang mit einer Schaumgummileiste 10 versehen, damit eine gute Abdichtung erreicht wird.

An der Aussenseite des Spiralgehäuses 2 ist eine elektronische Steuerungseinrichtung 11 für das Radialgebläse 3 angeordnet. An der Temperaturmischklappe 8 sind zwei Leistungstransistoren 12 und 13 befestigt, die über ein Kabel 14 mit der Steuerungseinrichtung 11 verbunden sind. Durch diese Anordnung der Leistungstransistoren 12 und 13, die bekanntlich mit einer erheblichen Verlustleistung behaftet sind und dementsprechende Wärmeentwicklung aufweisen, wird die Wärme von den Leistungstransistoren 12 und 13 gut auf die gesamte Fläche der Temperaturmischklappe 8 übertragen und durch den an der Klappe entlanggeführten Luftstrom ständig abgeführt. An der Temperaturmischklappe 8 ist ausserdem ein Temperaturfühler 24 befestigt, durch den die Steuerungseinrichtung 11 sowie die Leistungstransistoren 12, 13 bei Überschreiten einer maximal zulässigen Temperatur ausschaltbar sind.

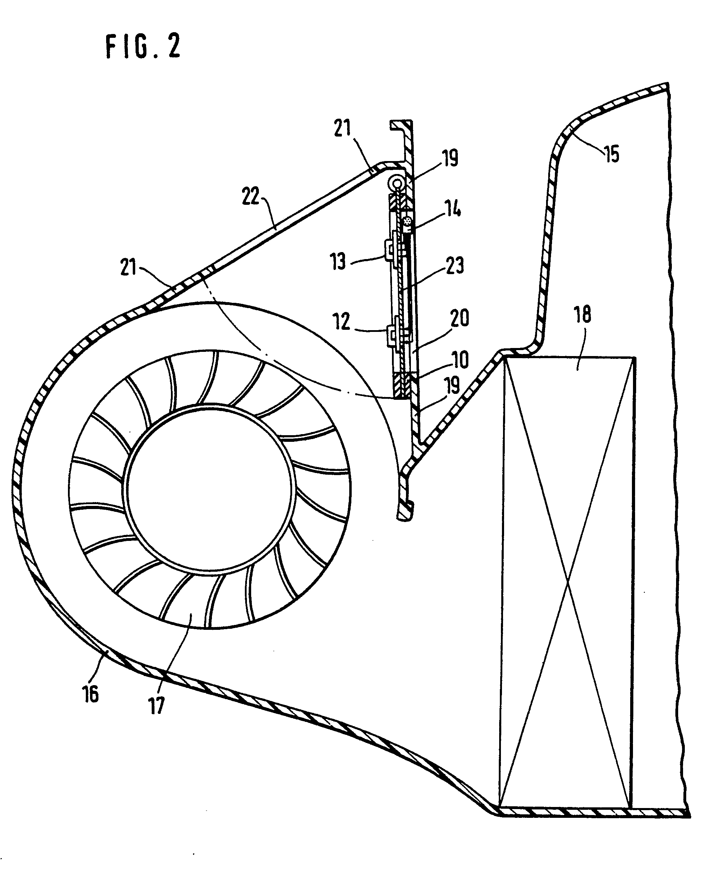

In Fig. 2 ist ein Ausschnitt einer Kraftfahrzeug-Klimaanlage gezeigt, wobei mit 15 das Gehäuse und mit 16 das Spiralgehäuse eines Radialgebläses 17 bezeichnet ist. Dem Radialgebläse 17 nachgeschaltet befindet sich in dem Gehäuse 15 ein Verdampfer 18. In einer Gehäusewand 19 befindet sich eine Öffnung 20 für die Umluft und in einer Gehäusewand 21 befindet sich eine Öffnung 22 für die Frischluft. Die Gehäusewände 19 und 21 sind in einem Winkel zueinander angeordnet, und die Öffnungen 20 und 22 sind durch eine schwenkbare Klappe 23 wahlweise absperrbar. In diesem Fall ist die Klappe 23 zur Beeinflussung der jeweiligen Anteile von Frischluft und Umluft vorgesehen. Die Klappe 23 weist an ihren Dichtflächen eine Gummileiste 10 auf. Ebenso wie bei der Temperaturmischklappe in Fig. 1 sind auch an der Klappe 23 zwei Leistungstransistoren 12 und 13 befestigt und mittels eines Kabels 14 mit einer in der Zeichnung nicht dargestellten elektronischen Steuerungseinrichtung verbunden. Die Klappe 23 besteht aus einer metallenen Platte mit guter Wärmeleitfähigkeit, so dass die von den Leistungstransistoren in Folge der Verlustleistung entwickelte Wärme gut abgeführt wird.

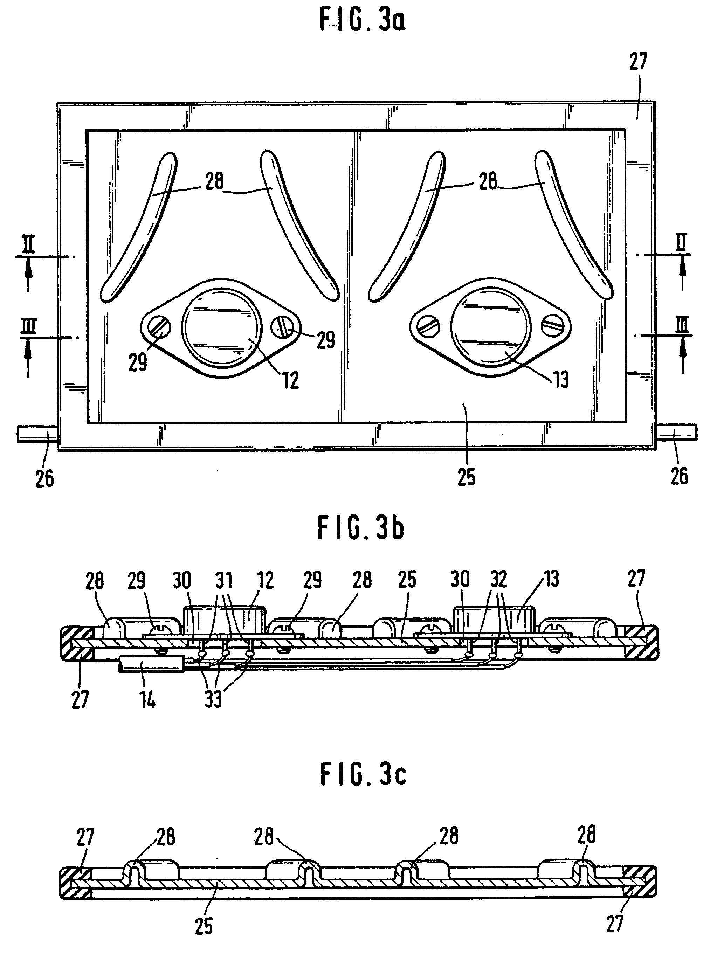

In Fig. 3a ist die Draufsicht auf eine Absperrklappe 25 gezeigt, die zwei Lagerzapfen 26 zur schwenkbaren Lagerung und eine Dichtleiste 27 aufweist. Die Klappe 25 besitzt ausserdem noch Sicken 28, die zum Leiten des Luftstromes dienen. An der Klappe 25 sind zwei Leistungstransistoren 12 und 13 mittels Schrauben 29 befestigt. Anstelle der Sicken können die Leitelemente 28 auch auf andere Weise, beispielsweise durch angeschweisste Blechstreifen, gebildet sein.

Fig. 3b zeigt einen Schnitt nach der Linie III-III in Fig. 3a. Aus dieser Ansicht wird deutlich, dass die Klappe 25 zwei Öffnungen 30 besitzt, durch die jeweils die Anschlussstifte 31 und 32 der Leistungstransistoren 12 und 13 auf die Rückseite der Klappe 25 geführt sind. An die Anschlussstife 31 und 32 der beiden Leistungstransistoren 12 und 13 sind jeweils die einzelnen Drähte 33 des Verbindungskabels 14 angelötet.

Fig. 3 zeigt einen Schnitt nach der Linie II-II in Fig. 3a. Aus dieser Darstellung ist ersichtlich, wie die zum Leiten des Luftstromes dienenden Sicken 28 aus dem Material der Klappe 25 herausgedrückt sind.

Fig. 4a zeigt die Draufsicht auf eine Klappe 35, an der nicht nur die Leistungstransistoren 12 und 13, sondern darüber hinaus auch die gesamte elektronische Steuereinrichtung untergebracht ist. Zwischen den beiden Leistungstransistoren 12 und 13 befindet sich in der Klappe 35 eine Öffnung 36, die durch eine haubenförmige Abdeckung 37 luftdicht verschlossen ist. Auf der Rückseite der Klappe 35 ist eine Leiterplatte 38, die eine elektronische Steuerungseinrichtung 43 trägt, mittels Schrauben 39 befestigt.

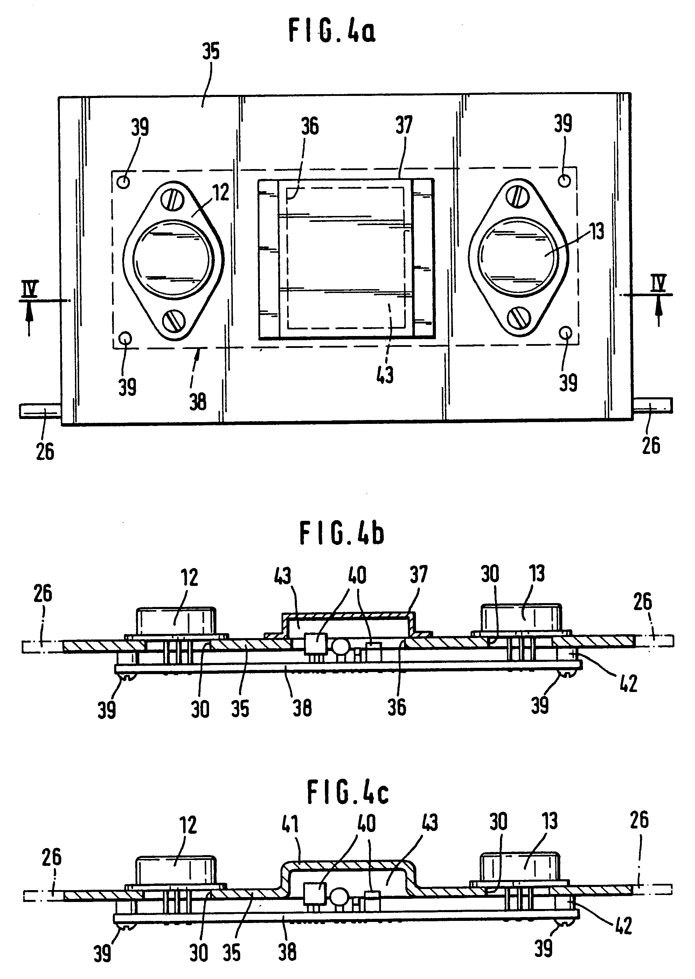

Fig. 4b zeigt einen Schnitt nach der Linie IV-IV in Fig. 4a. Aus dieser Ansicht ist ersichtlich, dass die Leiterplatte 38 mittels Distanzstücken 42 in einem bestimmten Abstand zur Klappe 35 befestigt ist. Die Anschlussstifte 31 und 32 der Leistungstransistoren 12 und 13 ragen durch die Leiterplatte und sind mit den entsprechenden Leiterbahnen, die sich auf der der Klappe 35 abgewandten Seite der Leiterplatte 38 befinden, verlötet. Im Bereich der Öffnung 36 der Klappe 35 sind auf der Leiterplatte 38 die Bauelemente der elektronischen Steuereinrichtung angeordnet, wobei sich die Bauelemente 40 der elektronischen Steuerungseinrichtung 43 in den durch die haubenartige Abdeckung 37 gebildeten Hohlraum erstrecken. Die Anschlüsse der Bauelemente 40 sind ebenfalls auf der entgegengesetzten Seite der Leiterplatte 38 mit Leiterbahnen verlötet.

Fig. 4c zeigt eine ähnliche Anordnung wie Fig. 4b, jedoch mit dem Unterschied, dass die Klappe 35 keine Öffnung 36 und Abdeckung 37 besitzt, sondern der für die Bauelemente 40 der Steuerungseinrichtung 43 benötigte Raum in Form einer aus dem Material der Klappe 35 geformten Wölbung 41 geschaffen ist.

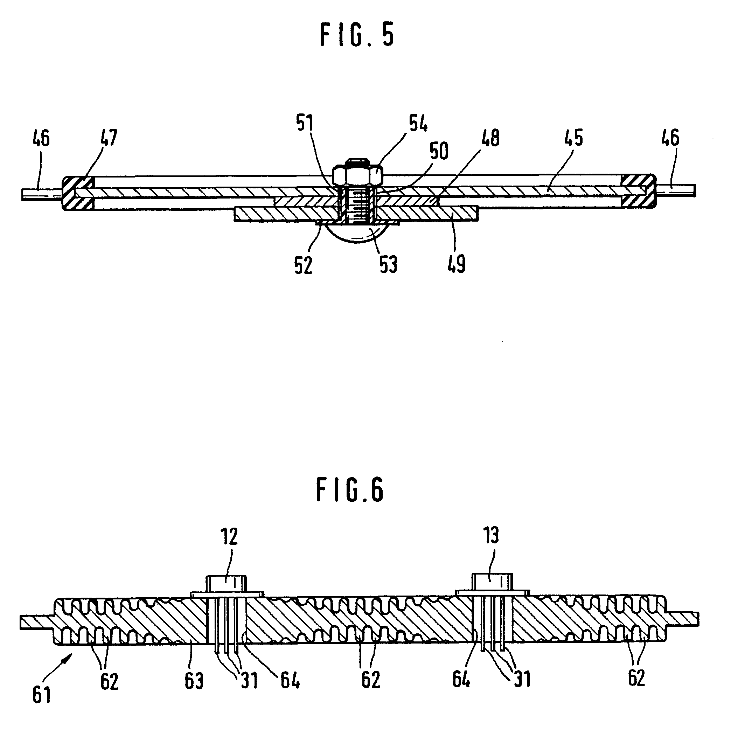

Fig. 5 zeigt einen Schnitt durch eine Klappe 45, die mit Lagerzapfen 46 zur schwenkbaren Lagerung sowie mit einer Dichtleiste 47 versehen ist. An der Klappe 45, die aus einem metallischen Werkstoff mit guter elektrischer und thermischer Leitfähigkeit besteht, liegt in flächigem Kontakt ein PTC-Widerstand 48, der sowohl zur Leistungsabstufung als auch zur temperaturabhängigen Strombegrenzung eines Gebläsemotors dient. Auf der der Klappe 45 abgewandten Seite des PTC-Widerstandes 48 liegt eine Metallplatte 49 in flächigem Kontakt. Dadurch, dass sowohl die Klappe 45 als auch die Platte 49 als elektrischer Leiter ausgebildet sind, dienen diese als elektrische Anschlüsse für den PTC-Widerstand 48. In der Klappe 45, dem PTC-Widerstand 48 und der Platte 49 befindet sich einen durchgehende Bohrung 50, in der eine Isolierhülse 51 mit einem an der Platte 49 anliegenden Kragen 52 angeordnet ist. Durch die Isolierhülse 51 ragt eine Schraube 53, deren Kopf an dem Kragen 52 anliegt und auf deren Gewinde eine Mutter 54 gedreht ist, mittels der die Einheit — bestehend aus Klappe 45, PTC-Widerstand 48 und Platte 49 — verspannt ist. Anstelle der Schraube 53 und Mutter 54 könnte auch ein Niet- oder ein anderes geeignetes Verbindungsmittel vorgesehen sein.

In Fig. 6 ist eine als Fliesspressteil hergestellte Klappe 61 dargestellt, die Verdickungen 63 aufweist. Im Bereich der Verdickungen 63 sind die Leistungstransistoren 12, 13 befestigt, deren Anschlussstifte 31, 32 durch Öffnungen 64 geführt sind. Neben den Verdickungen 63 sind an der Klappe 61 mehrere Rippen 62 angeordnet, die sowohl die Aufgabe haben, die wärmeabgebende Fläche zu vergrössern, als auch zum Leiten der Luft dienen.

Wie sich aus den vorstehenden Ausführungsbeispielen ergibt, ist die Anordnung von elektrischen Leistungsbauteilen mit grosser Wärmeentwicklung auf Klappen, die vom Luftstrom beaufschlagt werden, zweckmässig. Ebenso ist es auch möglich, auf der Klappe selbst eine Isolierschicht und darauf entsprechende Bahnen mit geeigneter Widerstandscharakteristik aufzutragen. Durch derart gebildete Leistungswiderstände wird nicht nur die Montage zusätzlicher Bauelemente auf die Platte vermieden, sondern sie zeichnet sich auch dadurch aus, dass dem Luftstrom kein grösserer Widerstand entgegengesetzt wird, als bei herkömmlichen ebenen Klappen.

Eine weitere Ausführungsform besteht darin, dass die Klappe aus einem Rahmen und einer darauf lösbar befestigten Metallplatte gebildet wird. Die elektronischen Bauteile und ggf. die Steuerungseinrichtung werden von dieser Metallplatte getragen. Im Falle eines Defektes der elektrischen Schaltung können auf diese Weise die elektronischen Bauteile bzw. die Steuerungseinrichtung sehr leicht ausgewechselt werden, indem lediglich die komplett bestückte Platte demontiert bzw. montiert wird.

**Patentansprüche**

1. Kraftfahrzeug-Heizungs- und/oder -Klimaanlage mit mindestens einem Gebläse (3) und mindestens einer den Gebläse-Luftstrom beeinflussenden metallischen Klappe (8) und mit einer elektrischen Steuerungseinrichtung (11) zur Drehzahlregelung bzw. -Abstufung, wobei die Steuerungseinrichtung mindestens ein mit erheblicher Wärmeentwicklung behaftetes elektronisches Bauteil aufweist, dadurch gekennzeichnet, dass das elektronische Bauteil (12, 13, 48) unmittelbar auf der Klappe (8, 23, 25, 35, 45, 61) befestigt ist und mit dieser in guter wärmeleitender Verbindung steht, und dass stets mindestens eine Seite der Klappe vom Gebläse-Luftstrom beaufschlagt ist.

2. Anlage nach Anspruch 1, dadurch gekennzeichnet, dass die Klappe (61) als Fliesspressteil hergestellt ist und im Bereich der elektronischen Bauteile (12, 13) Verdickungen (63) vorgesehen sind.

3. Anlage nach einem der Ansprüche 1 und 2, dadurch gekennzeichnet, dass als elektronisches Bauteil zwei Leistungstransistoren (12, 13) vorgesehen sind, die mittels eines Kabels (14) mit der Steuerungseinrichtung (11) verbunden sind, wobei die Klappe (25, 35, 61) im Bereich der Leistungstransistoren (12, 13) Öffnungen (40, 64) besitzt, durch die Anschlussstifte (31, 32) der Leistungstransistoren (12, 13) auf die Rückseite der Klappe (25, 35, 61) geführt sind.

4. Anlage nach einem der Ansprüche 1 bis 3, dadurch gekennzeichnet, dass die Klappe (8) dem Gebläse (3) nachgeschaltet und als Temperaturmischklappe (8) ausgebildet ist.

5. Anlage nach einem der Ansprüche 1 bis 3, dadurch gekennzeichnet, dass die Klappe (23) auf der Saugseite des Gebläses (17) angeordnet und als Frischluft-/Umluft-Weiche (23) ausgebildet ist.

6. Anlage nach einem der Ansprüche 2 bis 5, dadurch gekennzeichnet, dass die Klappe (25, 61) Mittel (28, 62) zur Vergrösserung der wärmeübertragenden Oberfläche und/oder zum Leiten des Luftstromes aufweist.

7. Anlage nach Anspruch 6, dadurch gekennzeichnet, dass die Mittel (28, 62) durch entsprechend geformte Sicken (28) im Material der Klappe (25), durch an der Klappe (61) angeformte Rippen (62) oder durch angeschweisste Blechstreifen gebildet sind.

8. Anlage nach Anspruch 3, dadurch gekennzeichnet, dass auf der Rückseite der Klappe eine Leiterplatte (38) befestigt ist, auf der die elektrische Steuerungseinrichtung (43) angeordnet ist.

9. Anlage nach Anspruch 8, dadurch gekennzeichnet, dass die Klappe (35) eine zwischen den Leistungstransistoren (12, 13) befindliche Öffnung (36) aufweist, die mit einer haubenförmigen Abdeckung (37) versehen ist, und Bauelemente (40) der elektrischen Steuerungseinrichtung (43) sich in die Öffnung (36) erstrecken.

10. Anlage nach Anspruch 8, dadurch gekennzeichnet, dass die Klappe (35) zwischen den Leistungstransistoren (12, 13) eine Wölbung (41) aufweist, in welche sich die Bauelemente (40) der elektronischen Steuerungseinrichtung (43) erstrecken.

11. Anlage nach einem der Ansprüche 8 bis 10, dadurch gekennzeichnet, dass die Bauelemente (40) der elektronischen Steuerungseinrichtung (43) mit einer Kunststoffabdeckung versehen oder in Kunstharz eingegossen sind und/oder die gesamte Leiterplatte (38) mit einem Kunststoffüberzug versehen ist.

12. Anlage nach Anspruch 1, dadurch gekennzeichnet, dass das elektronische Bauteil ein PTC-Widerstand (48) ist, der mit seiner der Klappe (45) abgewandten Seite an einer metallischen Platte (49) liegt und die Klappe (45) sowie die Platte (49) als elektrische Anschlüsse für den PTC-Widerstand (48) dienen.

13. Anlage nach einem der Ansprüche 1 bis 12, dadurch gekennzeichnet, dass die Klappe (8, 23, 25, 35, 45, 61) aus einem Rahmen und einer abnehmbaren Platte besteht, und die elektronischen Bauteile (12, 13, 48, 57) auf der Platte befestigt sind.

14. Anlage nach einem der Ansprüche 1 bis 13, dadurch gekennzeichnet, dass auf der Klappe (8, 23, 25, 35, 45, 61) mindestens ein Temperaturfühler (24) angeordnet ist.

## Claims

1. Motor vehicle heating and/or air conditioning system comprising at least one fan (3) and at least one metallic flap valve (8) influencing the air flow from the fan and comprising an electrical control unit (11) for rotary speed control or grading, the control device comprising at least one electronic component which is subject to considerable heat development, characterised in that the electronic component (12, 13, 48) is mounted directly on the flap valve (8, 23, 25, 35, 45, 61), being conducted thereto in a readily heat conductive manner and in that at least one side of the flap valve is at all times exposed to the air stream from the fan.

2. System according to Claim 1, characterised in that the flap valve (61) is produced as an extrusion and in that thickened portions (63) are provided in the region of the electronic components (12, 13).

3. System according to one of Claims 1 and 2, characterised in that provided as the electronic component are two power transistors (12, 13) connected by a cable (14) to the control device (11), the flap valve (25, 35, 61) having in the region of the power transistors (12, 13) apertures (30, 64) through which the connecting pins (31,32) of the power transistors (12, 13) pass to the back of the flap valve (25, 35, 61).

4. System according to one of Claims 1 to 3, characterised in that the flap valve (8) is downstream of the fan (3) and is constructed as a temperature mixing valve (8).

5. System according to one of Claims 1 to 3, characterised in that the flap valve (23) is disposed on the intake side of the fan (17) and is constructed as a fresh air/ambient air switch (23).

6. System according to one of Claims 2 to 5, characterised in that the flap valve (25, 61) comprises means (28, 62) for enlarging the heat transmitting surface and/or for conducting the air flow.

7. System according to Claim 6, characterised in that the means (28, 62) consist of correspondingly shaped beads (28) in the material of the valve (25), ribs (62) integral with the valve (61) or welded-on strips of sheet metal.

8. System according to Claim 3, characterised in that there is on the back of the valve a conductor board (38) on which the electrical conrol device (43) is disposed.

9. System according to Claim 8, characterised in that the valve (35) comprises, between the power transistors (12, 13), an aperture (36) which is provided with a hood-shaped covering (37) and in that component elements (40) of the electrical control device (43) extend into the aperture (36).

10. System according to Claim 8, characterised in that the valve (35) comprises, between the power transistors (12, 13), a convexly curved portion (41) into which extend the component elements (40) of the electronic control device (43).

11. System according to one of Claims 8 to 10, characterised in that the component elements (40) of the electronic control device (43) are provided with a synthetic plastics covering or are cast into synthetic resin and/or the entire conductor board (38) is provided with a synthetic plastics coating.

12. System according to Claim 1, characterised in that the electronic component is a PTC resistor (48) of which the side remote from the valves (45) bears on a metallic plate (49), the valve (45) as well as the plate (49) serving as electrical connections for the PTC resistor (48).

13. System according to one of Claims 1 to 12, characterised in that the valve (8, 23, 25, 35, 45, 61) consists of a frame and a removable plate on which the electronic components (12, 13, 48, 57) are fixed.

14. System according to one of Claims 1 to 13, characterised in that at least one temperature (24) is disposed on the valve (8, 23, 25, 35, 45, 61).


**Revendications**


1. Equipement de chauffage et/ou de climatisation de véhicule automobile comportant au moins une soufflante (3), au moins un volet (8) métallique influençant le flux d'air délivré par la soufflante et un dispositif de commande électrique (11) pour la régulation ou la gradation de la vitesse de rotation et qui contient au moins un composant électronique présentant un important dégagement de chaleur, ledit équipement étant caractérisé en ce que le composant électrique (12, 13, 48) est fixé directement sur le volet (8, 23, 25, 35, 45, 61) auquel il est relié avec une bonne conduction thermique; et un côté du volet au moins est toujours chargé par le flux d'air délivré par la soufflante.

2. Equipement selon revendication 1, caractérisé en ce que le volet (61) est réalisé par filage et présente des renflements (63) au voisinage des composants électroniques (12, 13).

3. Equipement selon une des revendications 1 ou 2, caractérisé en ce que le composant électronique est constitué par deux transistors de puissance (12, 13) reliés par un câble (14) au dispositif de commande (11), le volet (25, 35, 61) présentant des ouvertures (30, 64) que les broches (31, 32) des transistors de puissance (12, 13) traversent vers la face arrière du volet (25, 35, 61).

4. Equipement selon une quelconque des revendications 1 à 3, caractérisé en ce que le volet (8) est monté en aval de la soufflante (3) et réalisé sous forme d'un volet mélangeur de température (8).

5. Equipement selon une quelconque des revendications 1 à 3, caractérisé en ce que le volet (23) est disposé du côté aspiration de la soufflante (17) et réalisé sous forme d'un volet inverseur air frais-air recylcé (23).

6. Equipement selon une quelconque des revendications 2 à 5, caractérisé en ce que le volet (25, 61) comprend des moyens (28, 62) pour accroître la surface de transmission de la chaleur et/ou diriger le flux d'air.

7. Equipement selon revendication 6, caractérisé en ce que les moyens (28, 62) sont constitués par des moulures (28) de forme appropriée dans le matériau du volet (25), des nervures formées sur le volet (61) ou des rubans de tôle soudés.

8. Equipement selon revendication 3, caractérisé en ce qu'une carte imprimée (38) portant le dispositif de commande électrique (43) est fixée sur la face arrière du volet.

9. Equipement selon revendication 8, caractérisé en ce que le volet (35) présente entre les transistors de puissance (12, 13) une ouverture (36) munie d'un couvercle (37) en forme de capot et dans laquelle s'étendent des composants (40) du dispositif de commande électrique (43).

10. Equipement selon revendication 8, caractérisé en ce que le volet (35) présente entre les transistors de puissance (12, 13) un bombement (41) dans lequel s'étendent les composants (40) du dispositif de commande électronique (43).

11. Equipement selon une quelconque des revendications 8 à 10, caractérisé en ce que les composants (40) du dispositif de commande électronique (43) sont munis d'un recouvrement plastique ou encapsulés dans une résine synthétique et/ou l'ensemble de la carte imprimé (38) est recouvert de matière plastique.

12. Equipement selon revendication 1, caractérisé en ce que le composant électronique est une résistance CTP (48), dont la face opposée au volet (45) est appliquée sur une plaquette métallique (49); et le volet (45) ainsi que la plaquette (49) constituent les connexions électriques de la résistance CTP (48).

13. Equipement selon une quelconque des revendications 1 à 12, caractérisé en ce que le volet (8, 23, 25, 35, 45, 61) est constitué par un cadre et une plaque amovible; et les composants électroniques (12, 13, 48, 57) sont fixés sur la plaque.

14. Equipement selon une quelconque des revendications 1 à 13, caractérisé en ce qu'un capteur de température (24) au moins est disposé sur le volet (8, 23, 25, 35, 45, 61).

# FIG.1

0 143 176

FIG. 2

## F.I.G. 3a

## FIG. 3b

## FIG. 3c

# FIG. 4a

# FIG. 4b

# FIG. 4c

# FIG. 5

46  47  51  54  50  48  45  46

52  53  49

# FIG.6

12  13

61  62  63  31  64  62  64  31  62